# EUROPEAN PATENT APPLICATION

(11) **EP 1 587 149 A2**
(43) Date of publication of application: **19.10.2005**
(21) Application number: 05007999.5
(22) Date of filing: 12.04.2005
(51) Int. Cl.: H01L 31/048, H01L 31/02

(54) **A terminal box for a solar battery module and a method of mounting it**

(30) Priority: 13.04.2004 JP 2004117828
(71) Applicant: Sumitomo Wiring Systems, Ltd., Yokkaichi-City, Mie, 510-8503 (JP)
(72) Inventor: Yoshikawa, Hiroyuki, Yokkaichi-city Mie 510-8503 (JP); Higashikozono, Makoto, Yokkaichi-city Mie 510-8503 (JP)
(74) Representative: Müller-Boré & Partner Patentanwälte

(57) **Abstract**

An object of the present invention is to provide a terminal box for a solar battery module having good heat discharging characteristics and good connection reliability.

A bypass diode 50 is comprised of a mesa bear chip diode 51 and a pair of conductor plates 52 connected with the bear chip diode 51 while holding the bear chip diode 51 therebetween. The respective conductor plates 52 are superimposed on terminal plates 30 juxtaposed on a base plate 11 along their plane direction, and ultrasonic vibration is applied to each superimposed portion 60 to join it with the corresponding terminal plate 30. Out of the conductor plates 52, an N-conductor plate 52A is thicker than a P-conductor plate 52B.

## Description

The present invention relates to a terminal box for a solar battery module and to a method of mounting it.

Generally, a solar energy generation system is constructed to supply direct-current electricity from a solar battery panel laid on the roof of a house to the respective electric equipments via an inverter or the like. The solar battery panel is comprised of a plurality of solar battery modules, and electrodes of the respective solar battery modules are connected in series or in parallel via terminal boxes.

A known terminal box is constructed such that a plurality of terminal plates are juxtaposed in a box, ends of the terminal plates at one side being connectable with positive and negative electrodes drawn out from the underside of the solar battery module and the other ends thereof being connectable with cables for external connection, and bear chip diodes span between adjacent terminal plates (see, for example, Japanese Patent Publication No. 3498945). The bear chip diode is for shorting an inverse current at the time of an inverse load from one cable for external connection to the other and comprised of a diode functioning portion and a pair of conductor pieces connected with the diode functioning portion by soldering while holding the diode functioning portion therebetween. The respective conductor pieces are also connected with the corresponding terminal plates by soldering. The bear chip diode has an advantage of being inexpensive and taking up a smaller area in the box as compared to a diode of the package type.

In the above case, heat of molten solder is transferred to the diode functioning portion via the conductor pieces while the conductor pieces are solder-welded to the corresponding terminal plates, with the result that solder applied between the diode functioning portion and the conductor pieces is molten again, leading to poor connection between the diode functioning portion and the conductor pieces.

As a countermeasure, it was thought to connect the conductor piece with the corresponding terminal plate by resistance welding. However, by resistance welding, it is necessary to provide the terminal plate with unevenness and concentrate a current on spots. Thus, a contact area of the conductor piece and the terminal plate becomes smaller, resulting in a problem that heat generated by the diode functioning portion cannot be effectively discharged to the terminal plate.

The present invention was developed in view of the above problem and an object thereof is to provide a terminal box for a solar battery module having good heat discharging characteristics and good connection reliability.

This object is solved according to the invention by the features of the independent claims. Preferred embodiments of the invention are subject of the dependent claims.

According to the invention, there is provided a terminal box for a solar battery module, comprising:
a box main body,
a plurality of terminal plates juxtaposed in the box main body and connectable with positive and negative electrodes of a solar battery module via respective cables, and
a rectifying device, the rectifying device spanning between two corresponding terminal plates and including a rectifying-device main body and a pair of conductor plates connected with the rectifying-device main body,
wherein the pair of conductor plates are at least partly superimposed on the corresponding terminal plates along the plane direction thereof, and ultrasonic vibration is applied to superimposed portions to join the conductor plates with the corresponding terminal plates.

The pair of conductor plates are at least partly superimposed on the corresponding terminal plates substantially along the plane direction thereof and ultrasonic vibration is applied to these superimposed portions to join the conductor plates and the terminal plates. Thus, as compared to a case where they are solder-welded, the welding operation can be carried out within a shorter period of time, thereby suppressing a temperature increase. As a result, connection reliability is ensured without adversely affecting the connections between the rectifying-device main body and the conductor plates. Further, since a joined area of the conductor plate and the terminal plate typically is larger by ultrasonic welding than by resistance welding, heat discharging characteristics are good in letting the heat generated by the rectifying-device main body to escape toward the terminal plate.

According to a preferred embodiment of the invention, the rectifying device is provided for bypassing at the time of an inverse load.

Preferably, the rectifying device main body is chip-shaped rectifying-device main body and/or the pair of conductor plates are connected with the rectifying-device main body while holding the rectifying-device main body therebetween.

According to a further preferred embodiment of the invention, there is provided a terminal box for a solar battery module, comprising:
a box main body,
a plurality of terminal plates juxtaposed in the box main body and connectable with positive and negative electrodes of a solar battery module,
cables for external connection connectable with the terminal plates, and
a rectifying device for bypassing at the time of an inverse load, the rectifying device spanning between two corresponding terminal plates and including a chip-shaped rectifying-device main body and a pair of conductor plates connected with the rectifying-device main body while holding the rectifying-device main body therebetween,
wherein the pair of conductor plates are superimposed on the corresponding terminal plates along the plane direction thereof, and ultrasonic vibration is applied to superimposed portions to join the conductor plates with the corresponding terminal plates.

Preferably, the rectifying-device main body is a mesa bear chip diode and, out of the pair of conductor plates, an N-conductor plate connectable with an N-area of the bear chip diode is thicker than a P-conductor plate connectable with a P-area of the bear chip diode.

Since the N-conductor plate is thicker than the P-conductor plate, the heat generated by the rectifying-device main body can be effectively let to escape via the N-conductor plate, wherefore the heat discharging characteristics are better. Since a contact area of the N-area with the N-conductor plate is larger than that of the P-area with the P-conductor plate in the mesa bear chip diode, heat is actively discharged from the N-conductor plate.

Further preferably, at least one of the conductor plates (preferably the P-conductor plate) is provided with a stress relieving portion for absorbing a stress created upon applying the ultrasonic vibration, the stress relieving portion includes at least one narrow strip piece formed by making a bore or recess in the conductor plate (preferably the P-conductor plate) at an intermediate position substantially along the extending direction of the conductor plate (preferably the P-conductor plate) and a lateral edge of the base end of the narrow strip piece preferably is arcuately or roundedly formed.

Since the conductor plate (preferably the P-conductor plate) is provided with the stress relieving portion, the stress created by the ultrasonic vibration can be absorbed. The stress relieving portion includes the narrow strip piece formed by making the bore or recess in the conductor plate (preferably the P-conductor plate) at the intermediate position substantially along the extending direction. Since the lateral edge of the base end of the narrow strip piece preferably is arcuately formed, a situation where the base end of the narrow strip piece is fractured by the ultrasonic vibration can be avoided.

Most preferably, a plurality of narrow strip pieces are provided.

Since a plurality of narrow strip pieces are provided, the heat discharge characteristics can be better as compared to a case where only one narrow strip piece is provided.

According to the invention, there is further provided a terminal box for a solar battery module, in particular according to the above invention or a preferred embodiment thereof, comprising:
a plurality of terminal plates connectable with positive and negative electrodes of a solar battery module via respective cables,
a base plate on which the terminal plates are substantially juxtaposed, and
a rectifying device preferably for bypassing at the time of an inverse load, the rectifying device spanning between two corresponding terminal plates and including a rectifying-device main body and a pair of conductor plates connected with the rectifying-device main body preferably while holding the rectifying-device main body therebetween,
wherein the pair of conductor plates are at least partly superimposed on the corresponding terminal plates along the plane direction thereof, the superimposed portions are welded to be joined with the corresponding terminal plates, and one or more holes for permitting an access to the terminal plates are formed in the base plate at positions substantially corresponding to the superimposed portions.

According to a preferred embodiment of the invention, there is further provided a terminal box for a solar battery module, comprising:
a plurality of terminal plates connectable with positive and negative electrodes of a solar battery module,
cables for external connection connectable with the terminal plates,
a base plate on which the terminal plates are juxtaposed, and
a rectifying device for bypassing at the time of an inverse load, the rectifying device spanning between two corresponding terminal plates and including a chip-shaped rectifying-device main body and a pair of conductor plates connected with the rectifying-device main body while holding the rectifying-device main body therebetween,
wherein the pair of conductor plates are superimposed on the corresponding terminal plates along the plane direction thereof, the superimposed portions are welded to be joined with the corresponding terminal plates, and holes for permitting an access to the terminal plates are formed in the base plate at positions corresponding to the superimposed portions.

Since the holes for permitting an access to the terminal plates are formed in the base plate at the positions corresponding to the superimposed portions, ultrasonic welding can be applied with the terminal plate and the conductor plate held between an anvil and a horn chip, for example, by inserting the leading end of the anvil into the hole to bring it into contact with the terminal plate.

According to the invention, there is provided a method of mounting or assembling a terminal box for a solar battery module, comprising the following steps:
providing a box main body,
arranging a plurality of terminal plates juxtaposed in the box main body to be connectable with positive and negative electrodes of a solar battery module via respective cables, and
providing a rectifying device, the rectifying device spanning between two corresponding terminal plates and including a rectifying-device main body and a pair of conductor plates connected with the rectifying-device main body,
at least partly superimposing the pair of conductor plates on the corresponding terminal plates along the plane direction thereof, and
applying ultrasonic vibration to superimposed portions to join the conductor plates with the corresponding terminal plates.

According to the invention, there is provided a method of mounting or assembling a terminal box for a solar battery module, in particular according to the above invention or a preferred embodiment thereof, comprising the following steps:
arranging a plurality of terminal plates connectable with positive and negative electrodes of a solar battery module via respective cables on a base plate, and
providing a rectifying device, the rectifying device spanning between two corresponding terminal plates and including a rectifying-device main body and a pair of conductor plates connected with the rectifying-device main body,
at least partly superimposing the pair of conductor plates on the corresponding terminal plates along the plane direction thereof,
welding the superimposed portions to be joined with the corresponding terminal plates, and
forming one or more holes for permitting an access to the terminal plates in the base plate at positions substantially corresponding to the superimposed portions.

According to a preferred embodiment of the invention, at least one of the conductor plates is provided with a stress relieving portion for absorbing a stress created upon applying the ultrasonic vibration, the stress relieving portion includes at least one narrow strip piece formed by making a bore or recess in the conductor plate at an intermediate position along an extending direction of the conductor plate and a lateral edge of the base end of the narrow strip piece preferably is arcuately formed.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a plan view of a box main body according to one embodiment of the invention,
FIG. 2 is an enlarged plan view of a bypass diode,
FIG. 3 is a diagrammatic section showing the structure of a bear chip diode, and
FIG. 4 is a diagrammatic section showing a state where ultrasonic welding is applied with a terminal plate and a conductor plate held between an anvil and a horn chip.

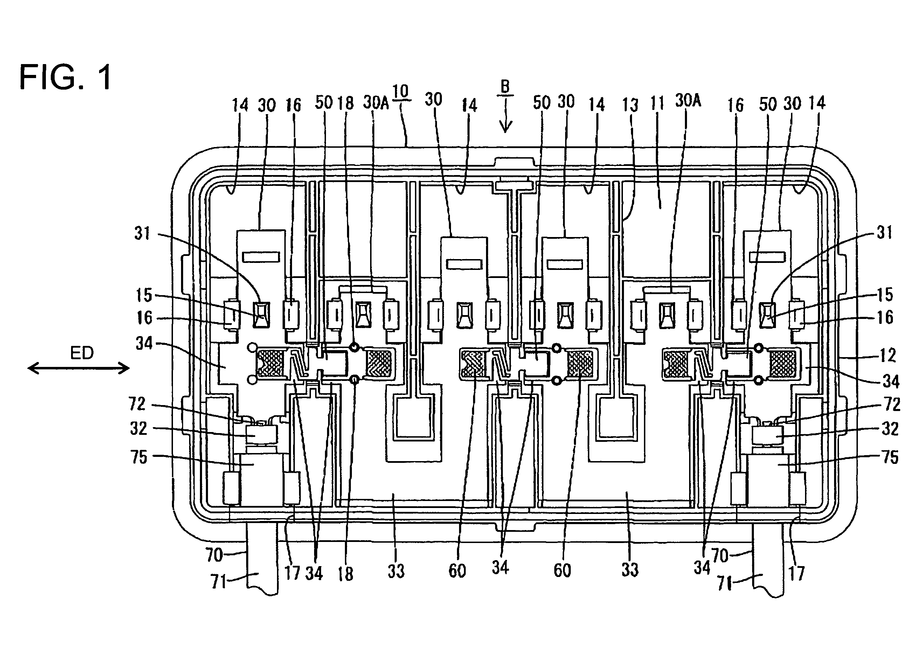

One preferred embodiment of the present invention is described with reference to FIGS. 1 to 4. A terminal box B for a solar battery module according to this embodiment is or is to be mounted on (preferably the underside or lateral side of) a solar battery module (not shown) having a multitude of solar battery cells connected in series arranged on the outer surface thereof, and is provided with a box main body 10, a multitude of terminal plates 30 juxtaposed in the box main body 10, and bypass diodes for reverse current flow (corresponding to a preferred rectifying device) spanning between adjacent terminal plates 30.

The box main body 10 is made e.g. of a synthetic resin material substantially into a box shape having an open lateral or upper surface, and an insulating resin is at least partly filled into the inside of the box main body 10 while a cover (not shown) is mounted from the open side or above. More specifically, the box main body 10 is comprised of a (preferably substantially rectangular) base plate 11 on which the terminal plates 30 are arranged preferably substantially side by side, a side plate 12 standing up or projecting from the outer peripheral edge or edge portion of the base plate 11 to at least partly surround the base plate 11, and one or more partition walls 13 standing up or projecting at specified (predetermined or predeterminable) positions of the base plate 11 to partition the adjacent terminal plates 30. The base plate 11 is formed with one or more, e.g. four (preferably substantially rectangular) openings 14, and the leading ends of the corresponding terminal plates 30 at least partly face the respective openings 14. Leads (not shown) connected or connectable with positive and negative electrodes of the solar battery module are at least partly introduced into the respective openings 14 of the base plate 11 and are connectable with the leading ends of the terminal plates 30 by soldering.

One or more positioning projections 15 engageable with positioning holes 31 of the terminal plates 30 project from the lateral (upper) surface of the base plate 11 substantially in correspondence with the respective terminal plates 30. One or more, preferably a pair of resiliently deformable locking pieces 16 project at the (preferably substantially opposite) outer side(s) of each positioning projection 15. In the process of mounting the terminal plate 30, the respective locking pieces 16 are deformed outwardly, preferably to widen the spacing therebetween by being engaged with the (preferably substantially opposite) lateral edge(s) of the terminal plate 30. As the terminal plate 30 is properly mounted, the locking pieces 16 are at least partly restored to press the (opposite) lateral edge(s) of the terminal plate 30 from above, thereby preventing the terminal plate 30 from moving upward.

One or more notches 17 are formed at the (preferably substantially opposite) end(s) of the upper edge of the side plate 12. Cables 70 for external output are at least partly fitted into these notches 17 from above and one or more cable pressing portions 75 are further at least partly fitted thereinto to fix the cables 70, the fitted cable pressing portions 75 being integrally or unitarily continuous with the side plate 12. The partition wall(s) 13 is/are so arranged as to extend substantially along the outer shapes of the terminal plates 30, and the terminal plate(s) 30 can be mounted by being guided by the partition wall(s) 13.

The terminal plates 30 are formed by cutting or pressing an electrically conductive (preferably metal) plate into one or more strips. The terminal plates 30 arranged at the opposite ends of the base plate 11 are connected with the corresponding cables 70 for external output. An insulation coating 71 is at least partly stripped at an end of each cable 70 to expose a core 72, with which a wire connection portion, preferably a barrel portion 32, formed at an end of the terminal plate 30 is connected, preferably crimped or bent or folded into connection, thereby connecting the cable 70 and the terminal plate 30. It should be noted that an extending end of the cable 70 is connected with a connector portion (not shown).

Each pair of adjacent terminal plates 30 (excluding those connected with the cables 70) are integrally or unitarily coupled to each other via a coupling portion 33 at one end. One 30A of these terminal plates 30 is not provided with a contact with the lead of the solar battery module and preferably shorter than the other terminal plate 30 and has the leading end thereof at least partly surrounded by the partition walls 13. In other words, this terminal plate 30A is arranged to detour from the other terminal plate 30 without being directly involved in connection with the mating side, and a creepage distance for letting heat generated by a bear chip diode 51 (described later) escape is lengthened by this detour, thereby improving a heat discharging effect.

One or more attachment portions 34 are so provided at the (preferably substantially opposite) lateral edge(s) of each terminal plate 30 as to bulge out sideways, and the edges or edge portions of the attachment portions 34 at the projecting ends are opposed to each other between the adjacent terminal plates 30. One or more bypass diodes 50 span between the adjacent terminal plates 30. In the shown case, three bypass diodes 50 are arranged substantially on the same straight line while crossing the respective terminal plates 30.

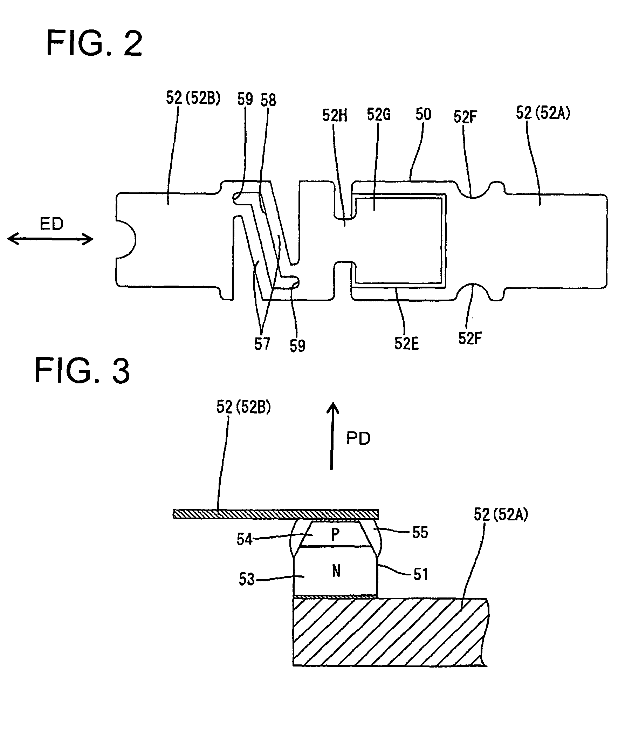

As shown in FIGS. 2 to 4, each bypass diode 50 is comprised of a diode, preferably a mesa bear or surface etched chip diode 51, and a pair of conductor plates 52 electrically connected with the bear chip diode 51 while holding the bear chip diode 51 from opposite sides along the thickness direction of the bypass diode 50 or sandwiched tehrebetween. As shown in FIG. 3, the bear chip diode 51 has such a multilayer structure that a P-area 54 is placed on or adjacent to an N-area 53 and the both areas 54, 53 preferably form a substantially trapezoidal or tronco-conic shape together, and/or a glass film 55 is provided at least partly around this multilayer structure. Out of the pair of conductor plates 52, an N-conductor plate 52A facing or contacting the N-area 53 preferably is thicker than (preferably more than about twice, more preferably more than about 6 times as thick as) a P-conductor plate 52B facing or contacting the P-area 54. For example, the thickness of the P-conductor plate 52B is about 0.1 mm, whereas that of the N-conductor plate 52A is about 0.8 to 1.0 mm.

The N-conductor plate 52A can be at least partly, preferably substantially entirely placed on the attachment portion 34 of the terminal plate 30 and is so superimposed on the attachment portion 34 in thickness direction as to extend substantially along the plane direction PD of the attachment portion 34. More specifically, the N-conductor plate 54A includes a contact portion 52E to be connected with the N-area 53 of the bear chip diode 51 preferably by soldering, welding or the like, and extends from the contact portion 52E in a direction at an angle different from 0° or 180°, preferably substantially normal to the extending direction of the corresponding terminal plate 30. One or more, preferably substantially arcuate recesses 52F are formed at the (preferably substantially opposite) lateral edge(s) of the N-conductor plate 52A at an intermediate position substantially along the extending direction of the N-conductor plate 52A, one or more projecting pins 18 projecting from the base plate 11 are engageable with the respective recesses 52F (see FIG. 1), and the conductor plate 52 is prevented from making loose movements along widthwise direction at the time of being welded to the terminal plate 30.

On the other hand, the P-conductor plate 52B is provided with a (preferably substantially rectangular) contact portion 52G to be connected with the P-area 54 of the bear chip diode 51 preferably by soldering, welding or the like, and extends from the contact portion 52G in a direction different, preferably substantially opposite from the N-conductor plate 52A via a constricted portion 52H. A bore or recess of a specified (predetermined or predeterminable) shape is formed in an intermediate section of the P-conductor plate 52B along the extending direction ED of the P-conductor plate 52B. As this bore is made, two or more narrow strip pieces 57 are formed to extend in a direction oblique to the inserting direction or extending direction ED. The P-conductor plate 52B is deformable to extend and contract along the extending direction ED thereof by the presence of the narrow strip pieces 57, thereby absorbing a stress or compensating changes in distance of the respective parts created at the time of being welded to the terminal plate 30. The two narrow strip pieces 57 preferably are substantially identically shaped and sized, have substantially the same width over the entire width, and are substantially parallel with each other with a slit 58 located in the middle or inbetween. Out of the lateral edges at the base ends of the respective narrow strip pieces 57, those facing the slit 58 are arcuately formed, whereby the lateral edges of the respective narrow strip pieces 57 are continuous with each other via substantially semicircular or rounded portions 59. In other words, the slit 58 has at its distal ends rounded portions.

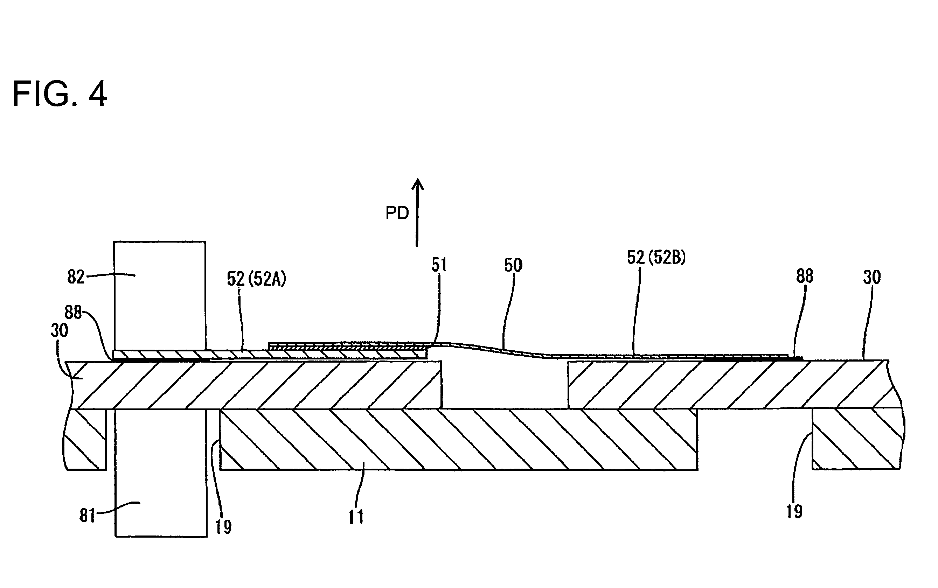

An extending end of the P-conductor plate 52B is at least partly superimposed on the corresponding terminal plate 30 along its plane direction PD (i.e. a direction normal to the plane), and (preferably ultrasonic) welding is at least partly applied to this superimposed portion 60 (hatched portion shown in FIG. 1) to weld or connect the superimposed portion 60 to the corresponding terminal plate 30. Likewise, the N-conductor plate 52A is at least partly superimposed on the corresponding terminal plate 30 along its plane direction PD, and (preferably ultrasonic) welding is at least partly applied to a superimposed portion 60 at the extending end of the N-conductor plate 52A away from the contact portion 52E to weld or connect the superimposed portion 60 to the corresponding terminal plate 30. Such ultrasonic welding preferably is realized by holding or positioning the terminal plate 30 and the conductor plate 52 between an anvil 81 and a horn chip 82. In order to enable this, the base plate 11 of the box main body 10 is formed at positions corresponding to the respective superimposed portions 60 with one or more holes 19 for permitting the at least partial entrance of the leading end of the anvil 81 for an access or for getting close to the terminal plate 30 (see FIG. 4).

Next, a method for producing the terminal box of this embodiment and functions and effects of this embodiment are described. First, the wire connection portion, preferably the barrel portions 32, of the terminal plates 30 are connected (preferably crimped or bent or folded into connection) with the cores 72 exposed at the ends of the corresponding cables 70, thereby connecting the terminal plates 30 and the cables 70. Subsequently, the terminal plates 30 are mounted to (preferably placed and fixed on) the base plate 11. At this time, the positioning projections 15 provided on the base plate 11 are at least partly inserted into the positioning holes 31 of the terminal plates 30, thereby positioning the terminal plates 30, and the terminal plates 30 are prevented from making upward movements by the resilient engagement with the locking piece(s) 16.

Subsequently, the cable pressing portions 75 are mounted from above or in an inserting direction thereof while covering the cables 70, whereby the cables 70 are fixed while being prevented from making loose movements. Thereafter, the bypass diode(s) 50 is/are placed to span between the adjacent terminal plates 30. At this time, the bypass diodes 50 can be positioned preferably by engaging the recess(es) 52F of the N-conductor plates 52A with the projecting pin(s) 18 of the base plate 11 for guiding. It should be noted that each bypass diode used here preferably is an integral or unitary assembly of the bear chip diode 51 and a pair of conductor plates 52.

Subsequently, the superimposed portion 60 of the conductor plate 52 and the terminal plate 30 is held or positioned between the anvil 81 and the horn chip 82 of an ultrasonic welding apparatus, and ultrasonic welding is applied thereto. More specifically, as shown in FIG. 4, after the leading end of the anvil 81 is at least partly inserted into the hole of the base plate 11 and the base plate 11 is placed (and preferably fixed) on the anvil 81, the horn chip 82 is lowered to preferably press the conductor plate 52 against the terminal plate 30 and heat is applied to the conductor plate 52, preferably ultrasonic vibration of a vibrating direction along the plane direction PD of the conductor plate 52 is applied to the horn chip 82, thereby ultrasonically welding the conductor plate 52 to the terminal plate 30. Then, the conductor plate 52 and the terminal plate 30 are connected with a (preferably ultrasonically) welded portion 88.

Thereafter, the box main body 10 is mounted (preferably adhered) to the side (preferably the underside) of the solar battery module preferably using an adhesive double coated tape or secured thereto using bolts. In the mounting process, the leads connected with the electrodes of the solar battery module are drawn into the box main body 10 through the respective openings 14 of the base plate 11 and connected with the leading ends of the terminal plates 30 preferably by soldering. Then, the insulating resin such as a silicone resin is filled into the box main body 10, and the cover is mounted to close the box main body 10. The crimp-connected parts, the solder-connected parts, the (ultrasonically) welded portions 88 and/or the like connected parts are sealed airtight by the insulating resin.

As described above, according to this embodiment, a pair of conductor plates 52 are at least partly superimposed on the corresponding terminal plates 30 along the plane direction PD thereof, and heat (preferably by ultrasonic vibration) is applied to these superimposed portions 60 to join the conductor plates 52 and the terminal plates 30. Thus, as compared to a case where they are solder-welded, the welding operation can be carried out within a shorter period of time, thereby suppressing a temperature increase. This results in the avoidance of a situation where the solder applied between the bear chip diode 51 and the conductor plates 52 is molten again, thereby ensuring connection reliability. Further, since the bear chip diode 51 and the conductor plates 52 can be connected by the lead-free solder having a low melting point in this way, a concomitant effect of being able to contribute to an environmental measure can also be obtained. Furthermore, since a joined area of the conductor plate 52 and the terminal plate 30 is larger by ultrasonic welding than by resistance welding, heat discharging characteristics are good in letting the heat generated by the bear chip diode 51 to escape toward the terminal plate 30.

Since the N-conductor plate 52A preferably is thicker than the P-conductor plate 52B, the heat generated by the bear chip diode 51 can be effectively let to escape via the N-conductor plate 52A, wherefore the heat discharging characteristics are better. Particularly in this embodiment, the heat discharging characteristics are even better since the N-conductor plate 52A and the terminal plate 30 are at least partly placed one over the other below the bear chip diode 51.

Further, since the P-conductor plate 52B is thinned and is bored at the intermediate position along the extending direction ED thereof to form the one or more narrow strip pieces 57, stresses created by the ultrasonic vibration are absorbed or dampened by the narrow strip pieces 57. In this case, a situation where the base ends of the narrow strip pieces 57 are fractured by the ultrasonic vibration can be avoided since the lateral edges of the narrow strip pieces 57 at the base ends are arcuately formed or rounded. Furthermore, since two narrow strip pieces 57 are provided, the heat discharging effect is better as compared to a case where only one narrow strip piece is provided.

Accordingly, to provide a terminal box for a solar battery module having good heat discharging characteristics and good connection reliability, a bypass diode 50 is preferably comprised of a mesa bear chip diode 51 and a pair of conductor plates 52 connected with the bear chip diode 51 while holding the bear chip diode 51 therebetween or sandwiching the diode 51. The respective conductor plates 52 are at least partly superimposed on terminal plates 30 juxtaposed on a base plate 11 along their plane direction PD, and ultrasonic vibration is applied to each superimposed portion 60 to join it with the corresponding terminal plate 30. Out of the conductor plates 52, an N-conductor plate 52A is thicker than a P-conductor plate 52B.

### <Other Embodiments>

The present invention is not limited to the above described and illustrated embodiment. For example, the following embodiments are also embraced by the technical scope of the present invention as defined by the claims. Beside the following embodiments, various changes can be made without departing from the scope and spirit of the present invention as defined by the claims.
(1) Although the box main body is entirely resin-sealed in the foregoing embodiment, it is sufficient to resin-seal at least around the connected parts such as the ultrasonically welded portions according to the present invention.
(2) Although two narrow strip pieces 57 are provided in the foregoing embodiment, three or more narrow strip pieces may be provided according to the present invention. Depending on cases, only one narrow strip piece may be provided.
(3) Although the anvil can enter the holes of the base plate in the foregoing embodiment, a welding instrument used for welding other than ultrasonic welding may enter the holes of the base plate according to the present invention.

### LIST OF REFERENCE NUMERALS

- B ...: terminal box for a solar battery module
- 10 ...: box main body
- 11 ...: base plate
- 30 ...: terminal plate
- 50 ...: bypass diode (rectifying device)
- 51 ...: bear chip diode
- 52 ...: conductor plate
- 52A ...: N-conductor plate
- 52B ...: P-conductor plate
- 57 ...: narrow strip piece
- 60 ...: superimposed portion
- 70 ...: cable

## Claims

1. A terminal box (B) for a solar battery module, comprising:
a box main body (10),
a plurality of terminal plates (30) juxtaposed in the box main body (10) and connectable with positive and negative electrodes of a solar battery module via respective cables (70), and
a rectifying device (50), the rectifying device (50) spanning between two corresponding terminal plates (30) and including a rectifying-device main body (51) and a pair of conductor plates (52A, 52B) connected with the rectifying-device main body (51),
wherein the pair of conductor plates (52A, 52B) are at least partly superimposed on the corresponding terminal plates (30) along the plane direction (PD) thereof, and ultrasonic vibration is applied to superimposed portions to join the conductor plates (52A, 52B) with the corresponding terminal plates (30).

2. A terminal box according to claim 1, wherein the rectifying device (50) is provided for bypassing at the time of an inverse load.

3. A terminal box according to one or more of the preceding claims, wherein the rectifying device main body is chip-shaped rectifying-device main body (51) and/or the pair of conductor plates (52A, 52B) are connected with the rectifying-device main body (51) while holding the rectifying-device main body (51) therebetween.

4. A terminal box according to one or more of the preceding claims, wherein the rectifying-device main body (51) is a mesa bear chip diode and, out of the pair of conductor plates (52A, 52B), an N-conductor plate (52A) connectable with an N-area of the bear chip diode (51) is thicker than a P-conductor plate (52B) connectable with a P-area of the bear chip diode (51).

5. A terminal box according to one or more of the preceding claims, wherein at least one (52B) of the conductor plates (52A, 52B) is provided with a stress relieving portion (57) for absorbing a stress created upon applying the ultrasonic vibration, the stress relieving portion includes at least one narrow strip piece (57) formed by making a bore or recess in the conductor plate (52B) at an intermediate position along an extending direction (ED) of the conductor plate (52B) and a lateral edge of the base end of the narrow strip piece (57) preferably is arcuately formed.

6. A terminal box according to claim 5, wherein a plurality of narrow strip pieces (57) are provided.

7. A terminal box (B) for a solar battery module, comprising:
a plurality of terminal plates (30) connectable with positive and negative electrodes of a solar battery module via respective cables (70),
a base plate (11) on which the terminal plates (30) are substantially juxtaposed, and
a rectifying device (50) preferably for bypassing at the time of an inverse load, the rectifying device (50) spanning between two corresponding terminal plates (30) and including a rectifying-device main body (51) and a pair of conductor plates (52A, 52B) connected with the rectifying-device main body (51) preferably while holding the rectifying-device main body (51) therebetween,
wherein the pair of conductor plates (52A, 52B) are at least partly superimposed on the corresponding terminal plates (30) along the plane direction (PD) thereof, the superimposed portions are welded to be joined with the corresponding terminal plates (30), and one or more holes (19) for permitting an access to the terminal plates (30) are formed in the base plate (11) at positions substantially corresponding to the superimposed portions.

8. A method of mounting a terminal box (B) for a solar battery module, comprising the following steps:
providing a box main body (10),
arranging a plurality of terminal plates (30) juxtaposed in the box main body (10) to be connectable with positive and negative electrodes of a solar battery module via respective cables (70), and
providing a rectifying device (50), the rectifying device (50) spanning between two corresponding terminal plates (30) and including a rectifying-device main body (51) and a pair of conductor plates (52A, 52B) connected with the rectifying-device main body (51),
at least partly superimposing the pair of conductor plates (52A, 52B) on the corresponding terminal plates (30) along the plane direction (PD) thereof, and
applying ultrasonic vibration to superimposed portions to join the conductor plates (52A, 52B) with the corresponding terminal plates (30).

9. A method of mounting a terminal box (B) for a solar battery module, comprising the following steps:
arranging a plurality of terminal plates (30) connectable with positive and negative electrodes of a solar battery module via respective cables (70) on a base plate (11), and
providing a rectifying device (50), the rectifying device (50) spanning between two corresponding terminal plates (30) and including a rectifying-device main body (51) and a pair of conductor plates (52A, 52B) connected with the rectifying-device main body (51),
at least partly superimposing the pair of conductor plates (52A, 52B) on the corresponding terminal plates (30) along the plane direction (PD) thereof,
welding the superimposed portions to be joined with the corresponding terminal plates (30), and
forming one or more holes (19) for permitting an access to the terminal plates (30) in the base plate (11) at positions substantially corresponding to the superimposed portions.

10. A method according to claim 8 or 9, wherein at least one (52B) of the conductor plates (52A, 52B) is provided with a stress relieving portion (57) for absorbing a stress created upon applying the ultrasonic vibration, the stress relieving portion includes at least one narrow strip piece (57) formed by making a bore or recess in the conductor plate (52B) at an intermediate position along an extending direction (ED) of the conductor plate (52B) and a lateral edge of the base end of the narrow strip piece (57) preferably is arcuately formed.
